# EUROPEAN PATENT APPLICATION

(11) **EP 1 887 109 A2**
(43) Date of publication of application: **13.02.2008**
(21) Application number: 07253014.0
(22) Date of filing: 31.07.2007
(51) Int. Cl.: C30B 23/00, C30B 29/40

(54) **Aluminum nitride single crystal**

(30) Priority: 01.08.2006 JP 2006210195; 15.06.2007 JP 2007159134
(71) Applicant: NGK INSULATORS, LTD., Nagoya-City, Aichi Pref. 467-8530 (JP)
(72) Inventor: Kobayashi, Yoshimasa, c/o NGK Insulators Ltd., Nagoya City, Aichi-ken, 467-8530 (JP)
(74) Representative: Paget, Hugh Charles Edward

(57) **Abstract**

In an aluminum nitride single crystal , Si and C are dissolved, and a lattice constant of an a-axis is within a range of 3.0935 [Å] or more to 3.1110 [Å] or less. In such a way, a lattice constant of the aluminum nitride single crystal is controlled in response to lattice constants of functional layers to be formed, thus making it possible to form, with good crystallinity, the functional layers having a variety of compositions.

## Description

### CROSS REFERENCE TO RELATED APPLICATION

This application is based upon and claims the benefit of priority from a Japanese Patent Application No. TOKUGAN 2006-210195, filed on August 1, 2006 and a Japanese Patent Application No. TOKLTGAN 2007-159134, filed on June 15, 2007; the entire contents of which are incorporated herein by reference.

### BACKGROUND OF THE INVENTION

### 1. Field of the Invention

The present invention relates to an aluminum nitride single crystal suitable for use in a light-emitting element.

### 2. Description of the Related Art

In general, as disclosed in Japanese Patent Laid-Open Publication No. 2003-152264, aluminum gallium nitride (AlGaN) is formed as a light-emitting layer on an aluminum nitride (AlN) single crystalline substrate for a light-emitting element. However, a lattice constant (3.1114 Å) of AlN is smaller than a lattice constant (3.150 Å in the case where Al/Ga is equal to 1) of AlGaN, and accordingly, when the AlGaN layer is formed on the AlN substrate, a tensile stress remains in the AlGaN layer, whereby a crack occurs on the AlGaN layer. As a result, it has been impossible to form a light-emitting layer good in crystallinity.

### SUMMARY OF THE INVENTION

The present invention has been made in order to solve such a problem as described above. It is an object of the present invention to provide an aluminum nitride single crystal capable of forming, with good crystallinity, functional layers having a variety of compositions.

An aluminum nitride single crystal according to a first aspect of the present invention is characterized in that Si and C are dissolved, and a lattice constant of an a-axis is within a range of 3.0935 [A] or more to 3.1110 [A] or less.

An aluminum nitride single crystal according to a second aspect of the present invention is characterized in that C and O are dissolved, and a lattice constant of an a-axis is within a range of 3.1115 [Å] or more to 3.1410 [Å] or less.

An aluminum nitride single crystal according to a third aspect of the present invention is characterized in that at least Si, C and O are dissolved, and a lattice constant of an a-axis is within a range of 3.0940 [A] or more to 3.1400 [Å] or less.

In accordance with the aluminum nitride single crystal according to the present invention, the lattice constant can be controlled within the predetermined ranges. Accordingly, the lattice constant of the aluminum nitride single crystal is controlled in response to lattice constants of the functional layers to be formed, thus making it possible to form, with good crystallinity, the functional layers having the variety of compositions.

### BRIEF DESCRIPTION OF THE DRAWINGS

Exemplary embodiments of the invention will become more fully apparent from the following description and appended claims, taken in conjunction with the accompanying drawings. Understanding that these drawings depict only exemplary embodiments and are, therefore, not to be considered limiting of the invention's scope, the exemplary embodiments of the invention will be described with additional specificity and detail through use of the accompanying drawings in which:
FIG. 1 is a schematic view showing a configuration of a single crystal production apparatus serving as an embodiment of the present invention.
FIG. 2 is a picture view of an optical microscope, showing a shape of a tip end portion of a seed crystal serving as an embodiment of the present invention.
FIG. 3 is a view for explaining plane orientations of an aluminum nitride crystal.

### DETAILED DESCRIPTION OF THE PREFERRED EMBODIMENTS

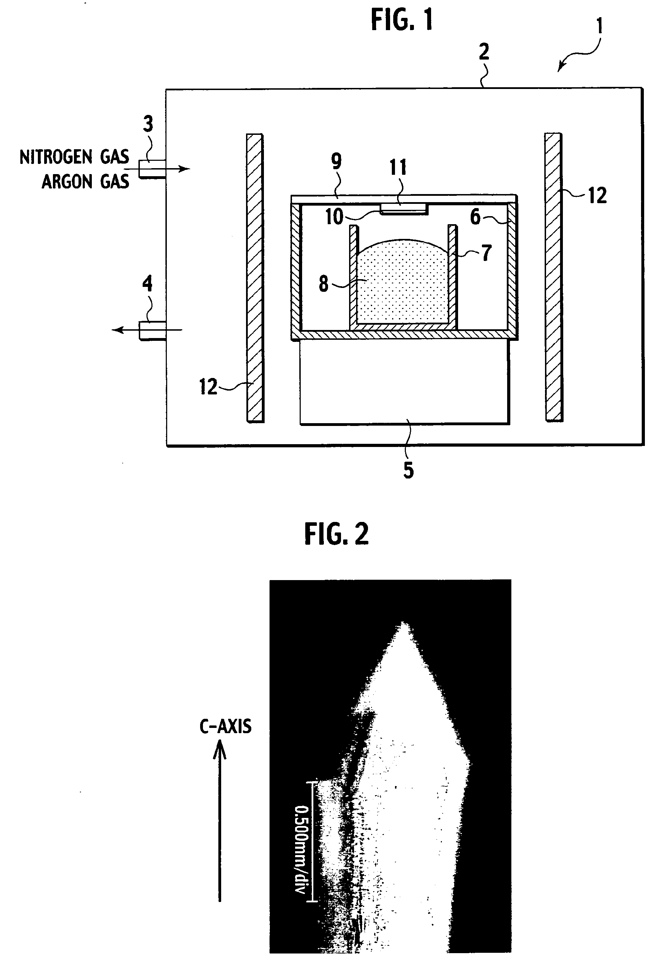

As shown in FIG. 1, a single crystal production apparatus 1 serving as an embodiment of the present invention includes a furnace 2, a gas supply port 3 that supplies inert gas such as nitrogen gas and argon gas to an inside of the furnace 2, a gas discharge port 4 that discharges the gas in the inside of the furnace 2, a body portion 6 that has an opening and is mounted on a mounting stage 5 in the furnace 2, a container 7 housed in an inside of the body portion 6, a raw material 8 housed in an inside of the container 7, a lid portion 9 that closes the opening of the body portion 6, a holding portion 11 that is provided on a back surface of the lid portion 9 and holds a seed crystal 10, and a heater 12 that heats up the inside of the furnace 2.

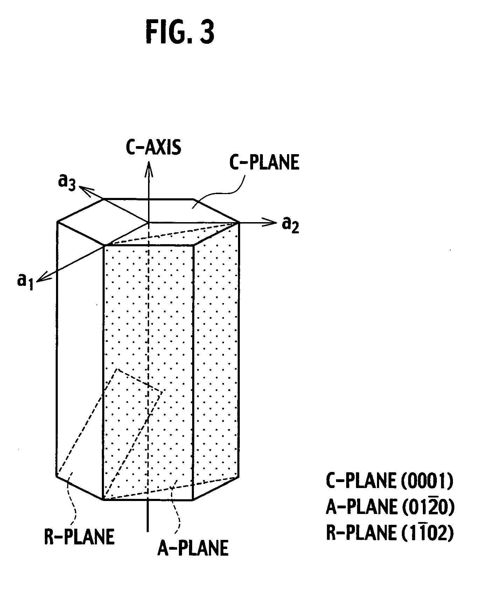

In the single crystal production apparatus 1, the seed crystal 10 is composed of a bar-like aluminum nitride single crystal in which a longitudinal direction is oriented to a c-axis, and has a hexagonal shape in cross section. Moreover, on a side portion of the seed crystal 10, on which the aluminum nitride crystal 8 is grown, six surfaces are exposed -(refer to FIG. 2). Furthermore, an exposed surface (A plane shown in FIG. 3) of the side portion has an inclination of 90° with respect to a {0001} plane. In the single crystal production apparatus 1 having such a configuration, a temperature in the furnace 2 is raised by the heater 12, whereby the gas is generated from the raw material 8. Then, the generated gas is further reacted with nitrogen in an atmosphere, whereby the aluminum nitride crystal is grown on the exposed surfaces of the seed crystal 10. Moreover, the inventor of the preset invention has found out that concentrations of Si, C, and O, which are contained in the aluminum nitride single crystal to be grown, can be adjusted by adjusting a concentration of CO in the atmosphere in the furnace 2 and concentrations of Si and C in the raw material 8.

Note that, in this case, the aluminum nitride single crystal is grown under a condition where a ratio of a growth rate thereof in an a-axis direction with respect to a growth rate thereof in the c-axis direction becomes 1 or more. Alternatively, the aluminum nitride single crystal is grown under a condition where the growth rate thereof in the a-axis direction becomes 100 µm or more to 2000 µm or less. In such a way, it is possible to produce an aluminum nitride single crystal excellent in productivity and more excellent in crystallinity. The inventors of the present invention have obtained such a finding as described above.

As described above, six surfaces having inclinations of 90° with respect to the {0001} plane are exposed on the side portion of the seed crystal 10, on which the aluminum nitride crystal 8 is grown. Accordingly, the aluminum nitride single crystal may be grown simultaneously on at least two of the exposed surfaces, preferably, on the six exposed surfaces. In accordance with such a production method, the growth rate of the aluminum nitride single crystal can be accelerated to a large extent.

### <Examples>

A description will be made below of examples of the aluminum nitride single crystal produced by using the above-described single crystal production apparatus 1, and examples of a film formed on the aluminum nitride single crystal.

### [Example 1]

In Example 1, first, an aluminum nitride single crystal was grown on the seed crystal 10 in which the exposed surfaces had inclinations of 90° with respect to the {0001} plane while dissolving C and O so that contents of C and O could be 0.18 [wt%] and 0.21 [wt%], respectively. When a lattice constant of the a-axis of the aluminum nitride single crystal of Example 1 was measured, the lattice constant of the a-axis was 3.1126 [Å]. Next, an AlN film was grown by the MOCVD method on the {0001} plane of the aluminum nitride single crystal of Example 1. When a half width of an X-ray rocking curve of the AlN film was measured, the half width was 54 [arcsec]. This result is shown in the following Table 1.

### [Example 2]

In Example 2, the same processing as that of Example 1 was performed except that C and O were dissolved so that the contents of C and O could be 0.37 [wt%] and 0.38 [wt%], respectively, whereby an aluminum nitride single crystal of Example 2 was obtained. When the lattice constant of the a-axis of the aluminum nitride single crystal of Example 2 was measured, the lattice constant of the a-axis was 3.1124 [Å]. Moreover, when the half width of the X-ray rocking curve of the AlN film was measured, the half width was 50 [arcsec]. This result is shown in the following Table 1.

### [Example 3]

In Example 3, the same processing as that of Example 1 was performed except that C and O were dissolved so that the contents of C and O could be 0.77 [wt%] and 0.82 [wt%], respectively, whereby an aluminum nitride single crystal of Example 3 was obtained. When the lattice constant of the a-axis of the aluminum nitride single crystal of Example 3 was measured, the lattice constant of the a-axis was 3.1139 [Å]. Moreover, when the half width of the X-ray rocking curve of the AlN film was measured, the half width was 80 [arcsec]. This result is shown in the following Table 1.

### [Example 4]

In Example 4, the same processing as that of Example 1 was performed except that C and O were dissolved so that the contents of C and O could be 2.66 [wt%] and 3.55 [wt%], respectively, whereby an aluminum nitride single crystal of Example 4 was obtained. When the lattice constant of the a-axis of the aluminum nitride single crystal of Example 4 was measured, the lattice constant of the a-axis was 3.1173 [Å]. Moreover, when the half width of the X-ray rocking curve of the AlN film was measured, the half width was 131 [arcsec]. This result is shown in the following Table 1.

### [Example 5]

In Example 5, an AlGaN (Al: Ga = 9: 1) film was grown on a surface of the aluminum nitride single crystal of Example 4. When the half width of the X-ray rocking curve of the AlGaN film was measured, the half width was 68 [arcsec]. This result is shown in the following Table 1.

### [Example 6]

In Example 6, an AlGaN (Al: Ga = 8: 2) film was grown on the surface of the aluminum nitride single crystal of Example 4. When the half width of the X-ray rocking curve of the AlGaN film was measured, the half width was 157 [arcsec]. This result is shown in the following Table 1.

### [Example 7]

In Example 7, first, an aluminum nitride single crystal was grown on the seed crystal 10 in which the exposed surfaces had inclinations of 90° with respect to the {0001} plane while dissolving C and O so that the contents of C and O could be 4.88 [wt%] and 6.51 [wt%], respectively. When the lattice constant of the a-axis of the aluminum nitride single crystal of Example 7 was measured, the lattice constant of the a-axis was 3.1231 [Å]. Next, the AlGaN film (Al: Ga = 8: 2) was grown by the MOCVD method on the (0001) plane of the aluminum nitride single crystal of Example 7. When the half width of the X-ray rocking curve of the AlGaN film was measured, the half width was 121 [arcsec]. This result is shown in the following Table 1.

### [Example 8]

In Example 8, an AlGaN (Al: Ga = 7: 3) film was grown on a surface of the aluminum nitride single crystal of Example 7. When the half width of the X-ray rocking curve of the AlGaN film was measured, the half width was 185 [arcsec]. This result is shown in the following Table 1.

### [Example 9]

In Example 9, first, an aluminum nitride single crystal was grown on the seed crystal 10 in which the exposed surfaces had inclinations of 90° with respect to the {0001} plane while dissolving C and O so that the contents of C and O could be 0.09 [wt%] and 0.12 [wt%], respectively. When the lattice constant of the a-axis of the aluminum nitride single crystal of Example 9 was measured, the lattice constant of the a-axis was 3.1115 [A]. Next, the AlN film was grown by the MOCVD method on the (0001) plane of the aluminum nitride single crystal of Example 9. When the half width of the X-ray rocking curve of the AlN film was measured, the half width was 41 [arcsec]. This result is shown in the following Table 1.

### [Example 10]

In Example 10, first, an aluminum nitride single crystal was crystal-grown on the seed crystal 10 in which the exposed surfaces had inclinations of 90° with respect to the {0001} plane while dissolving C and O so that the contents of C and O could be 11.02 [wt%] and 14.68 [wt%], respectively. When the lattice constant of the a-axis of the aluminum nitride single crystal of Example 10 was measured, the lattice constant of the a-axis was 3.1407 [Å]. Next, an AlGaN (Al: Ga = 6: 4) film was grown by the MOCVD method on the (0001) plane of the aluminum nitride single crystal of Example 10. When the half width of the X-ray rocking curve of the AlGaN film was measured, the half width was 60 [arcsec]. This result is shown in the following Table 1.

### [Example 11]

In Example 11, first, an aluminum nitride single crystal was crystal-grown on the seed crystal 10 in which the exposed surfaces had inclinations of 90° with respect to the {0001} plane while dissolving C and Si so that contents of C and Si could be 0.44 [wt%] and 1.04 [wt%], respectively. When the lattice constant of the a-axis of the aluminum nitride single crystal of Example 11 was measured, the lattice constant of the a-axis was 3.1110 [A]. Next, the AlN film was grown by the MOCVD method on the (0001) plane of the aluminum nitride single crystal of Example 11. When the half width of the X-ray rocking curve of the AlN film was measured, the half width was 45 [arcsec]. This result is shown in the following Table 1.

### [Example 12]

In Example 12, first, an aluminum nitride single crystal was crystal-grown on the seed crystal 10 in which the exposed surfaces had inclinations of 90° with respect to the {0001} plane while dissolving C and Si so that the contents of C and Si could be 17.91 [wt%] and 41.87 [wt%], respectively. When the lattice constant of the a-axis of the aluminum nitride single crystal of Example 12 was measured, the lattice constant of the a-axis was 3.0937 [Å]. Next, the AlN film was grown by the MOCVD method on the (0001) plane of the aluminum nitride single crystal of Example 12. When the half width of the X-ray rocking curve of the AlN film was measured, the half width was 383 [arcsec]. This result is shown in the following Table 1.

### [Example 13]

In Example 13, first, an aluminum nitride single crystal was crystal-grown on the seed crystal 10 in which the exposed surfaces had inclinations of 90° with respect to the {0001} plane while dissolving C, O and Si so that contents of C, O and Si could be 1.52 [wt%], 0.77 [wt%] and 2.22 [wt%], respectively. When the lattice constant of the a-axis of the aluminum nitride single crystal of Example 13 was measured, the lattice constant of the a-axis was 3.1114 [A]. Next, the A1N film was grown by the MOCVD method on a surface of the aluminum nitride single crystal of Example 13. When the half width of the X-ray rocking curve of the AlN film was measured, the half width was 42 [arcsec]. This result is shown in the following Table 1.

### [Example 14]

In Example 14, the same processing as that of Example 13 was performed except that C, O and Si were dissolved so that the contents of C, O and Si could be 1.73 [wt%], 0.77 [wt%] and 2.69 [wt%], respectively, whereby an aluminum nitride single crystal of Example 14 was obtained. When the lattice constant of the a-axis of the aluminum nitride single crystal of Example 14 was measured, the lattice constant of the a-axis was 3.1112 [Å]. Moreover, when the half width of the X-ray rocking curve of the AlN film was measured, the half width was 48 [arcsec]. This result is shown in the following Table 1.

### [Example 15]

In Example 15, the same processing as that of Example 13 was performed except that C, O and Si were dissolved so that the contents of C, O and Si could be 17.86 [wt%], 0.10 [wt%] and 41.60 [wt%], respectively, whereby an aluminum nitride single crystal of Example 15 was obtained. When the lattice constant of the a-axis of the aluminum nitride single crystal of Example 15 was measured, the lattice constant of the a-axis was 3.0940 [A]. Moreover, when the half width of the X-ray rocking curve of the AlN film was measured, the half width was 377 [arcsec]. This result is shown in the following Table 1.

### [Example 16]

In Example 16, first, an aluminum nitride single crystal was crystal-grown on the seed crystal 10 in which the exposed surfaces had inclinations of 90° with respect to the {0001} plane while dissolving C, O and Si so that contents of C, O and Si could be 11.11 [wt%], 14.50 [wt%] and 0.52 [wt%], respectively. When the lattice constant of the a-axis of the aluminum nitride single crystal of Example 16 was measured, the lattice constant of the a-axis was 3.1397 [Å]. Next, the AlGaN (Al: Ga = 7: 3) film was grown by the MOCVD method on a (0001) plane of the aluminum nitride single crystal of Example 16. When the half width of the X-ray rocking curve of the AlGaN film was measured, the half width was 127 [arcsec]. This result is shown in the following Table 1.

### [Example 17]

In Example 17, the same processing as that of Example 13 was performed except that C, O and Si were dissolved so that the contents of C, O and Si could be 13.65 [wt%], 9.09 [wt%] and 15.95 [wt%], respectively, whereby an aluminum nitride single crystal of Example 17 was obtained. When the lattice constant of the a-axis of the aluminum nitride single crystal of Example 17 was measured, the lattice constant of the a-axis was 3.1172 [A]. Moreover, when the half width of the X-ray rocking curve of the AlN film was measured, the half width was 143 [arcsec]. This result is shown in the following Table 1.

### [Example 18]

In Example 18, the same processing as that of Example 13 was performed except that C, O and Si were dissolved so that the contents of C, O and Si could be 0.35 [wt%], 0.18 [wt%] and 0.52 [wt%], respectively, whereby an aluminum nitride single crystal of Example 18 was obtained. When the lattice constant of the a-axis of the aluminum nitride single crystal of Example 18 was measured, the lattice constant of the a-axis was 3.1114 [Å]. Moreover, when the half width of the X-ray rocking curve of the AlN film was measured, the half width was 32 [arcsec]. This result is shown in the following Table 1.

### [Comparative example 1]

In Comparative example 1, the AlN film was grown on a surface of a SiC substrate in which the lattice constant of the a-axis was 3.0764 [Å]. When the half width of the X-ray rocking curve of the AlN film was measured, the half width was 851 [arcsec]. This result is shown in the following Table 1.

### [Comparative example 2]

In Comparative example 2, the AlN film was grown on a surface of a GaN substrate in which the lattice constant of the a-axis was 3.1892 [A]. When the half width of the X-ray rocking curve of the AlN film was measured, the half width was 1561 [arcsec]. This result is shown in the following Table 1.

**[Table 1]**

| | **Substrate material** | **Content of C(wt%)** | **Content of 0(wt%)** | **Content of Si(wt%)** | **Lattice constant of a-axis (Å)** | **Film composition** | **Crystallinity of film FWHM (arcsec)** |
|---|---|---|---|---|---|---|---|
| **Example 1** | **AIN** | **0.18** | **0.21** | **0** | **3.1126** | **AIN** | **54** |
| **Example 2** | **AIN** | **0.37** | **0.38** | **0** | **3.1124** | **AIN** | **50** |
| **Example 3** | **AIN** | **0.77** | **0.82** | **0** | **3.1139** | **AIN** | **80** |
| **Example 4** | **AIN** | **2.66** | **3.55** | **0** | **3.1173** | **AIN** | **131** |
| **Example 5** | **AIN** | **2.66** | **3.55** | **0** | **3.1173** | **AIGaN(Al:Ga=9:1)** | **68** |
| **Example 6** | **AIN** | **2.66** | **3.55** | **0** | **3.1173** | **AlGaN(Al:Ga=8:2)** | **157** |
| **Example 7** | **AIN** | **4.88** | **6.51** | **0** | **3.1231** | **AlGaN(Al:Ga=8:2)** | **121** |
| **Example 8** | **AIN** | **4.88** | **6.51** | **0** | **3.1231** | **AlGaN(Al:Ga=7:3)** | **185** |
| **Example 9** | **AIN** | **0.09** | **0.12** | **0** | **3.1115** | **AIN** | **41** |
| **Example 10** | **AIN** | **11.02** | **14.68** | **0** | **3.1407** | **AlGaN(Al:Ga=6:4)** | **60** |
| **Example 11** | **AIN** | **0.44** | **0** | **1.04** | **3.1110** | **AIN** | **45** |
| **Example 12** | **AIN** | **17.91** | **0** | **41.87** | **3.0937** | **AIN** | **383** |
| **Example 13** | **AIN** | **1.52** | **0.77** | **2.22** | **3.1114** | **AIN** | **42** |
| **Example 14** | **AIN** | **1.73** | **0.77** | **2.69** | **3.1112** | **AIN** | **48** |
| **Example 15** | **AIN** | **17.86** | **0.10** | **41.60** | **3.0940** | **AIN** | **377** |
| **Example 16** | **AIN** | **11.11** | **14.50** | **0.52** | **3.1397** | **AlGaN(Al:Ga=7;3)** | **127** |
| **Example 17** | **AIN** | **13.65** | **9.09** | **15.95** | **3.1172** | **AIN** | **143** |
| **Example 18** | **AIN** | **0.35** | **0.18** | **0.52** | **3.1114** | **AIN** | **32** |
| **Comparative example 1** | **SiC** | **-** | **-** | **-** | **3.0764** | **AlN** | **851** |
| **Comparative example 2** | **GaN** | **-** | **-** | **-** | **3.1892** | **AlN** | **1561** |

### [Evaluation]

As apparent from comparison of the half widths shown in Table 1, the crystallinities of the films grown on the aluminum nitride single crystals of Examples 1 to 18 are better than the crystallinities of the films grown on the substrates of Comparative examples 1 and 2. From this fact, it is found out that the functional layers having the variety of compositions can be formed with good crystallinity in accordance with the aluminum nitride single crystals of Examples 1 to 18.

In general, in the case of producing the aluminum nitride single crystal , O and C in impurities of the raw material and the atmosphere are prone to intrude into the aluminum nitride single crystal. Moreover, Si and C sometimes dissolve into the aluminum nitride single crystal from the seed crystal and a furnace member. Then, when C, O and Si are dissolved into the aluminum nitride single crystal , the lattice constant is changed, whereby the aluminum nitride single crystal sometimes becomes unsuitable as the substrate for forming the aluminum nitride film. From a technical viewpoint, it is extremely difficult to reduce amounts of all of C, O and Si into the aluminum nitride single crystal.

As opposed to this, it has been found out that the lattice constant of the aluminum nitride single crystal can be widely controlled by adding C, O and Si thereto in accordance with the aluminum nitride single crystals of Examples 13 to 18. According to this, Si and C are intentionally dissolved under a condition where C and O are prone to dissolve into the aluminum nitride single crystal , and on the contrary, O and C are intentionally dissolved under a condition where Si and C are prone to dissolve into the aluminum nitride single crystal , thus making it possible to produce an aluminum nitride single crystal having a target lattice constant.

For example, the following has been found out. When C and O are contained by 0.04 [wt%] and 0.06 [wt%], respectively, the aluminum nitride single crystal is controlled so that Si and C can be contained by 1.03 [wt%] and 0.44 [wt%], respectively, whereby the lattice constant of the aluminum nitride single crystal can be controlled to 3.1111 [Å] that is substantially the same as that of a pure aluminum nitride single crystal. Moreover, the following has been found out. On the contrary to the above, when Si and C are contained by 0.41 [wt%] and 0.18 [wt%], respectively, the aluminum nitride single crystal is controlled so that C and O can be contained by 0.35 [wt%] and 0.26 [wt%], respectively, whereby the lattice constant of the aluminum nitride single crystal can be controlled to 3.1116 [Å] that is substantially the same as that of the pure aluminum nitride single crystal.

The present invention is not limited to the description and the drawings which constitute a part of the disclosure of the present invention according to the embodiment. Specifically, it may be added that, needless to say, other embodiments, examples, operational technologies and the like, which are made by those skilled in the art based on the embodiment, are all included in the scope of the present invention.

## Claims

1. An aluminum nitride single crystal , wherein Si and C are dissolved, and a lattice constant of an a-axis is within a range of 3.0935 [A] or more to 3.1110 [Å] or less.

2. An aluminum nitride single crystal , wherein C and O are dissolved, and a lattice constant of an a-axis is within a range of 3.1115 [A] or more to 3.1410 [A] or less.

3. An aluminum nitride single crystal, wherein at least Si, C and O are dissolved, and a lattice constant of an a-axis is within a range of 3.0940 [A] or more to 3.1400 [A] or less.
